(19) Europäisches Patentamt
European Patent Office
Office européen des brevets

(11) **EP 0 490 309 B1**

(12) **EUROPÄISCHE PATENTSCHRIFT**

(45) Veröffentlichungstag und Bekanntmachung des Hinweises auf die Patenterteilung:
**28.05.1997 Patentblatt 1997/22**

(51) Int Cl.⁶: **G01R 33/04**

(21) Anmeldenummer: **91121038.3**

(22) Anmeldetag: **09.12.1991**

(54) **Magnetfeldsensor**

Magnetic field sensor

Capteur de champ magnétique

(84) Benannte Vertragsstaaten:
**DE FR GB IT NL SE**

(30) Priorität: **11.12.1990 DE 4039422**

(43) Veröffentlichungstag der Anmeldung:
**17.06.1992 Patentblatt 1992/25**

(73) Patentinhaber: **HONEYWELL AG**
**63067 Offenbach (DE)**

(72) Erfinder:
• **König, Axel, Dipl.-Ing.**
**W-6450 Hanau 8 (DE)**

• **Lang, Michael, Dipl.-Ing.**
**W-6144 Zwingenberg (DE)**

(74) Vertreter: **Herzbach, Dieter, Dipl.-Ing. et al**
**Honeywell Holding AG**
**Patent- und Lizenzabteilung**
**Postfach 10 08 65**
**63008 Offenbach (DE)**

(56) Entgegenhaltungen:
**EP-A- 0 065 762      DE-A- 1 591 871**
**DE-A- 3 824 267      US-A- 3 944 912**
**US-A- 4 059 796**

**Beschreibung**

Die vorliegende Erfindung bezieht sich auf einen Magnetfeldsensor nach dem Gattungsbegriff der Patentansprüche 1 und 4.

Aus der DE-A-15 91 871 ist eine Schaltungsanordnung zur Messung von Magnetfeldern mit einem sättigbaren ferromagnetischen Kern im Innern einer einzigen Sondenwicklung bekannt, die über eine Vollbrückenschaltung mit einem Sättigungsstrom ansteuerbar ist. Hierbei werden in der Vollbrückenschaltung paarweise über Kreuz angeordnete Schalttransistoren gleich lang geöffnet und sofort nach ihrem Schließen werden die in der anderen Brückendiagonalen angeordneten Schalttransistoren ebenfalls gleich lang geöffnet. Bei jeder Halbwelle des Erregerstromes in der einzigen Sondenwicklung entstehen Spitzenwerte des Sättigungsstromes, welche erfaßt und ausgewertet werden. Wenn kein äußeres Magnetfeld überlagert ist, so sind an einem Ladewiderstand gleich große Impulse abgreifbar. Bei einem vorliegenden äußeren Magnetfeld hingegen ergeben sich ungleich große Impulse.

Aus der DE-C-31 21 234 ist eine Schaltungsanordnung bekannt, bei der die Spule einer Meßsonde durch bipolare Ansteuerung mit einem Erregerstrom den gesamten Bereich von der negativen bis zur positiven Sättigung durchläuft. An der Spule werden jeweils Spannungsimpulse gemessen, die nach einer Exponentialfunktion abklingen. Die Zeitkonstante dieser Spannungsimpulse entspricht der jeweiligen Spuleninduktivität. Da diese Spuleninduktivität durch ein äußeres Magnetfeld gegenüber dem Nullpunkt des Erregerstromes verschoben ist, ergeben sich auf einer Seite des Nullpunktes mehr Spannungsimpulse mit großer Zeitkonstante als auf der anderen Seite. Durch Auszählung der Spannungsimpulse und Differenzbildung läßt sich ein Meßwert für die Stärke des äußeren Magnetfeldes gewinnen.

Es ist die Aufgabe der vorliegenden Erfindung, diese bekannten Schaltungsanordnungen weiter auszugestalten und in einer solchen Weise auszubilden, daß ein Meßverfahren ausgeübt werden kann, wie es aus der DE-OS 38 24 267 bereits bekannt ist, wo die bei Abschaltung eines Sättigungsstromes durch das äußere Magnetfeld veränderte Selbstinduktion ausgewertet wird. Die Lösung dieser Aufgabe gelingt gemäß den kennzeichnenden Merkmalen der unabhängigen Ansprüche 1 und 2. Eine weitere vorteilhafte Ausgestaltung des Magnetfeldsensors ist dem abhängigen Anspruch entnehmbar.

Anhand von in den Figuren der beiliegenden Zeichnung dargestellten Ausführungsbeispielen sei im folgenden die Erfindung näher erläutert. Es zeigen:

Fig. 1    eine Vollbrückenschaltung zum Betrieb der Sensorspule mit zugehöriger Auswerteschaltung;

Fig. 1a    ein Signaldiagramm zur Erläuterung der Betriebsweise der Schaltungsanordnung gemäß Fig. 1;

Fig. 2    eine Halbbrückenschaltung zum Betrieb der Sensorspule mit zugehöriger Auswerteschaltung; und

Fig. 2a    ein Signaldiagramm zur Erläuterung der Betriebsweise der Schaltungsanordnung gemäß Fig. 2.

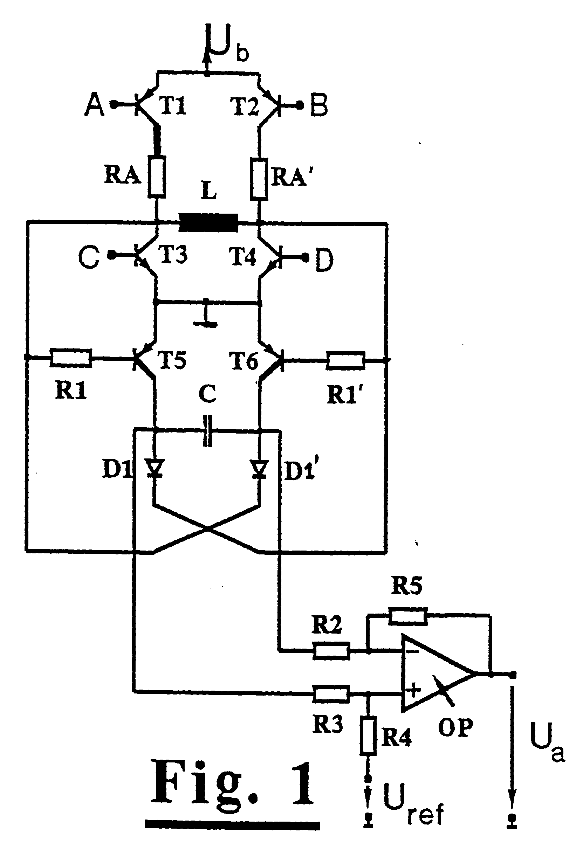

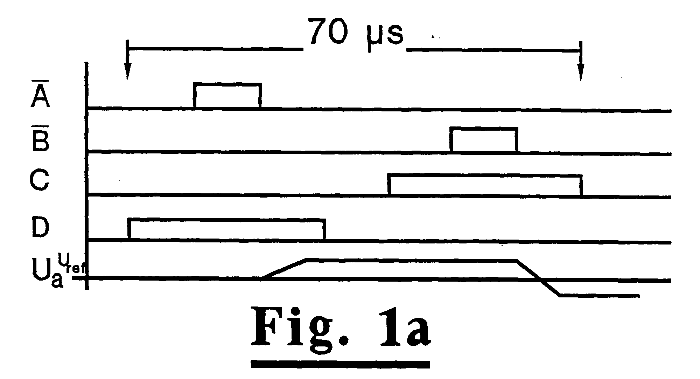

Gemäß Fig. 1 weist die Vollbrücke 4 bipolare Transistoren auf, wobei zwei pnp-Transistoren T1, T2 parallel zueinander geschaltet sind und mit ihren Emittern an der Betriebsspannung Ub liegen. Die Kollektoren der Transistoren T1, T2 sind über Abgleichwiderstände RA, RA' mit den Kollektoren von zwei parallelgeschalteten npn-Transistoren T3, T4 verbunden. Zwischen die gemeinsamen Kollektoren der Transistoren T1 bis T4 ist die Sensorspule L geschaltet, die vorbekannter Bauart ist und insbesondere geringe Remanenz und äußerst geringe Ummagnetisierungsverluste aufweist. Die Emitter der npn-Transistoren T3, T4 sind einmal an Masse gelegt und zum anderen an die Emitter von zwei weiteren parallelgeschalteten pnp-Transistoren T5, T6 angeschlossen. Die Basen der pnp-Transistoren T5, T6 sind über Widerstände R1, R1' einmal mit den beiden Enden der Sensorspule L verbunden und zum anderen über kreuzgekoppelte Dioden D1', D1 an die Kollektoren der Transistoren T6 und T5 angeschlossen. Zwischen den Kollektoren der Transistoren T5 und T6 ist ferner ein einziger Ladekondensator C angeordnet.

Die beiden Beläge des Kondensators C sind über Widerstände R2, R3 auf die beiden Eingänge eines Operationsverstärkers OP geschaltet, dessen Ausgang über einen Widerstand R5 auf den negativen Eingang zurückgeführt ist und dessen positiver Eingang über einen Widerstand R4 an Bezugsspannung liegt.

Die Differenzladestufe bestehend aus den Transistoren T5, T6, den Widerständen R1, R1', den Dioden D1, D1' und dem Kondensator C könnte auch entfallen, wenn die beiden Enden der Sensorspule L in herkömmlicher Weise über Dioden an getrennte Kondensatoren angeschlossen wären, wobei dann die Differenzspannung über beiden Kondensatoren ausgewertet werden müßte, wie dies aus der DE-OS 38 24 267 bekannt ist.

Die Differenzladestufe bietet jedoch den zusätzlichen Vorteil, daß nur ein Kondensator benötigt wird, so daß auch diesbezüglich Paarungsprobleme entfallen.

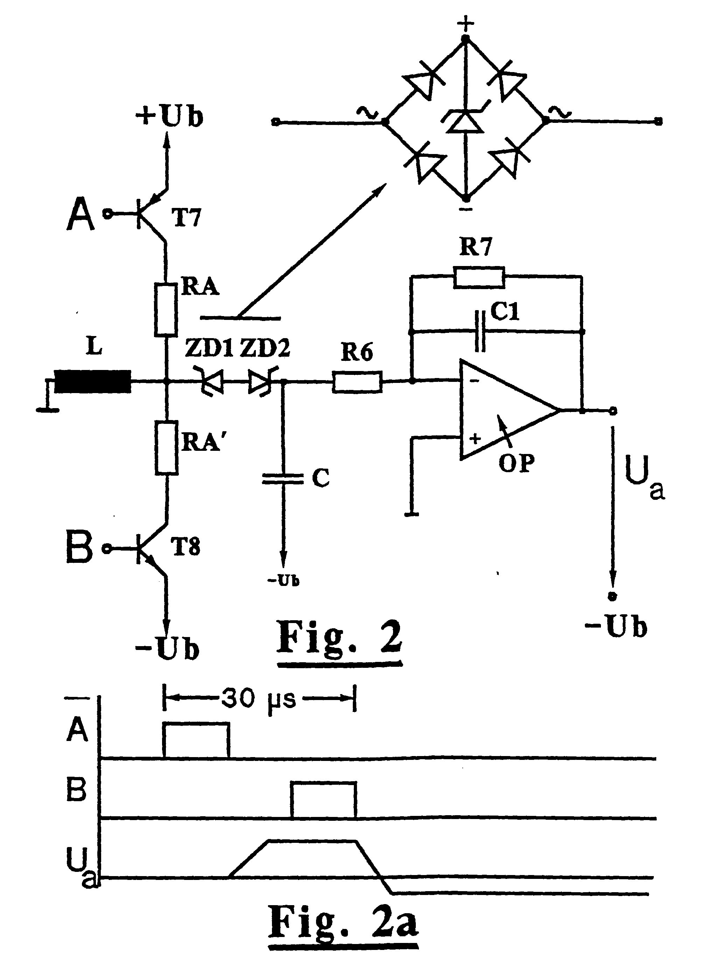

Die Wirkungsweise der Schaltungsanordnung gemäß Fig. 1 sei nunmehr unter Bezugnahme auf das Signaldiagramm gemäß Fig. 2a erläutert:

Zuerst wird der Transistor T4 durch das Signal D aufgesteuert und zeitversetzt etwas später erfolgt die Aufsteuerung des Transistors T1 durch das Signal $\overline{A}$. Jetzt fließt der Sättigungsstrom aus der Spannungsquelle Ub über den Transistor T1, den Widerstand RA, die Sensorspule L und den Transistor T4 nach Masse.

Beim Abschalten des Transistors T1, während der Transistor T4 noch geöffnet ist, wird der Strom durch die Sensorspule L abrupt unterbrochen und es entsteht infolge Selbstinduktivität am linken Spulenende eine negative Spannungsspitze, die den Transistor T5 öffnet, so daß Strom von Masse über den Transistor T5, den Kondensator C, die Diode D1' zum linken Spulenende fließt. Da der Transistor T4 noch durch das Signal D aufgesteuert ist, verringert sich die Magnetisierung der Sensorspule L bis zu dem durch das zu messende Magnetfeld vorgegebenen Wert. Die Ausgangsspannung Ua steigt hierbei auf einen der Ladung des Kondensators C entsprechenden Wert an. Nach der Abschaltung des Transistors T4 auf Grund fehlender Ansteuerung durch das Signal D bleibt die Ausgangsspannung Ua auf dem eingenommenen Wert.

Nach einer Pause wird zunächst der Transistor T3 durch das Signal C aufgesteuert und zeitversetzt etwas später wird auch der Transistor T2 durch das Signal B̄ geöffnet. Nunmehr fließt der Sättigungsstrom aus der Spannungsquelle Ub über den Transistor T2, den Widerstand RA', die Sensorspule L und den Transistor T3 nach Masse.

Beim Abschalten des Transistors T2, während der Transistor T3 noch geöffnet ist, wird wiederum der durch die Sensorspule L fließende Strom abrupt unterbrochen und es entsteht durch Selbstinduktion nunmehr am rechten Spulenende eine negative Spannungsspitze, durch die der Transistor T6 geöffnet wird, so daß Strom von Masse über den Transistor T6, den Kondensator C, die Diode D1 zum rechten Spulenende fließt. Da der Transistor T3 noch über das Signal C aufgesteuert ist, verringert sich die Magnetisierung der Sensorspule L bis zu dem durch das zu messende Magnetfeld vorgegebenen Wert. Die Ausgangsspannung Ua nimmt einen Wert entsprechend der nunmehr vertauschten Ladung auf dem Kondensator C an. Dieser Wert der Ausgangsspannung wird beibehalten, nachdem der Transistor T3 auf Grund fehlender Ansteuerung durch das Signal C geschlossen ist.

Somit stellt sich über dem Ladekondensator C nach zwei Ladevorgängen potentialfrei eine zum äußeren Magnetfeld linear proportionale Spannung mit geringem Offset ein.

Der in Fig. 1a dargestellte Zeittakt, der sich über 70 µs erstreckt, wird alle 1 ms an die Brückenschaltung angelegt, so daß sich insgesamt ein geringer Energieverbrauch der Schaltungsanordnung ergibt.

Gemäß Fig. 2 weist die Halbbrücke lediglich zwei bipolare Transistoren T7, T8 auf, die über zwei Abgleichwiderstände RA, RA' mit ihren Emitter/Kollektorstrecken in Reihe geschaltet sind und zwischen Versorgungsspannungen +Ub, -Ub unterschiedlicher Polarität betrieben werden. Der an die positive Versorgungsspannung angeschlossene Transistor T7 ist vom pnp-Leitfähigkeitstyp, während der an die negative Versorgungsspannung angeschlossene Transistor T8 vom npn-Leitfähigkeitstyp ist. Der gemeinsame Kollektoranschluß beider Transistoren ist einmal über die Sensorspule L gegen Bezugsspannung (Masse) geschaltet und zum anderen über entgegengesetzt in Reihe geschaltete Zenerdioden ZD1, ZD2 an einen Ladekondensator C angeschlossen. Die Ladespannung des Kondensators C ist über einen Widerstand R6 auf den negativen Eingang eines Operationsverstärkers OP geführt, dessen positiver Eingang an Bezugsspannung liegt und dessen Ausgang über die Parallelschaltung eines Widerstandes R7 und eines Kondensators C1 auf den negativen Eingang zurückgeführt ist.

Die zu paarenden Zenerdioden ZD1, ZD2 dienen als Schwellwertventile und ihre Durchlaßspannung ist so zu dimensionieren, daß sie etwas über der den Sättigungsstrom erzeugenden Spannung liegt.

Vorzugsweise kann die Reihenschaltung der beiden Zenerdioden durch eine Dioden-Vollbrückenschaltung mit einer in der Diagonale angeordneten Zenerdiode ersetzt werden.

Die Wirkungsweise der Schaltungsanordnung gemäß Fig. 2 ergibt sich unter Bezugnahme auf das Signaldiagramm gemäß Fig. 2a wie folgt:
Zunächst wird der Transistor T7 durch das Signal Ā aufgesteuert. Hierdurch fließt der Sättigungsstrom, während das Signal Ā anliegt, von +Ub über den Transistor T7, den Abgleichwiderstand RA und die Sensorspule L nach Masse. Auf Grund der Anordnung der Zenerdioden fließt hierbei kein Strom auf den Ladekondensator C.

Bei der Abschaltung des Transistors T7 auf Grund der Entfernung des Signales Ā wird der Ladekondensator C über die Zenerdioden auf Grund der entstehenden Abschaltspannung negativ aufgeladen. Nach Beendigung des Ladevorgangs wird der Transistor T8 durch das Signal B aufgesteuert, so daß nunmehr ein Sättigungsstrom in umgekehrter Richtung von -Ub über den Transistor T8, den Abgleichwiderstand RA' und die Sensorspule L nach Masse fließt. Auch hierbei wird die Ladung des Kondensators C auf Grund der vorhandenen Zenerdioden nicht beeinflußt. Beim Abschalten des Transistors T8 auf Grund der Entfernung des Signales B wird der Kondensator C über die Zenerdioden auf Grund der nunmehr entstehenden positiven Abschaltspannung in entgegengesetzter Richtung aufgeladen. Der nachgeschaltete integrierende Verstärker OP, R7, C1 integriert die von der Sensorspule L induzierte Ladespannung auf, wobei der den Schwellwert-Zenerdioden nachgeschaltete Kondensator C zusammen mit dem Widerstand R6 als ein die Signalverstärkung nicht beeinflussender Tiefpaß wirkt.

Am Ausgang des integrierenden Operationsverstärkers stellt sich nach zwei Entladevorgängen der Sensorspule L eine zum äußeren Magnetfeld linear proportionale Spannung Ua mit geringem Offset ein.

Der in Fig. 2a dargestellte Zeittakt, der sich über 30 µs erstreckt, wird alle 1 ms an die Brückenschaltung angelegt, so daß sich auch hier ein geringer Energieverbrauch der Schaltungsanordnung ergibt.

## Patentansprüche

1. Magnetfeldsensor mit einer einzigen Sensorspule (L), die in zeitlicher Abfolge und in entgegengesetzten Richtungen mit einem Sättigungsstrom gespeist wird, wobei die Sensorspule in der Diagonalen einer steuerbaren Vollbrückenschaltung zwischen einer Betriebsspannung ($U_b$) und einer Bezugsspannung betrieben wird und die vier Zweige der Vollbrückenschaltung jeweils Schalttransistoren (T1-T3) aufweisen, die paarweise über Kreuz angesteuert werden, um den Sättigungsstrom durch die Sensorspule zu erzeugen, **dadurch gekennzeichnet,** daß eine Differenzladestufe an die Vollbrückenschaltung angeschlossen ist, die einen ersten und einen zweiten Schalttransistor (T5, T6) umfaßt, wobei die Basis des ersten Schalttransistors (T5) mit dem einen Ende der Sensorspule (L) verbunden ist und über eine erste Diode (D1') an den einen Belag eines Kondensators (C) und an den Kollektor des zweiten Schalttransistors (T6) angeschlossen ist, wobei die Basis des zweiten Schalttransistors (T6) mit dem anderen Ende der Sensorspule (L) verbunden ist und über eine zweite Diode (D1) an den anderen Belag des Kondensators (C) und an den Kollektor des ersten Schalttransistors (T5) angeschlossen ist, wobei die Emitter beider Schalttransistoren (T5, T6) an die Bezugsspannung angeschlossen sind, daß sich die Ansteuerung (C, D) der die Sensorspule (L) an Bezugsspannung legenden Schalttransistoren (T3, T4) zeitlich über die Ansteuerung ($\overline{A}, \overline{B}$ )der die Sensorspule (L) an Betriebsspannung ($U_b$) anlegenden Schalttransistoren (T1, T2) hinaus erstreckt, und daß die beiden Beläge des Kondensators (C) an die Eingänge eines Operationsverstärkers (OP) angeschlossen sind, so daß die bei Abschaltung des Sättigungsstromes an der Sensorspule (L) auftretenden Spannungen differentiell ausgewertet werden.

2. Magnetfeldsensor mit einer einzigen Sensorspule (L), die in zeitlicher Abfolge und in entgegengesetzten Richtungen mit einem Sättigungsstrom gespeist wird, wobei die Sensorspule über Schalter (T7, T8) an Spannungen unterschiedlicher Polarität ($+U_b$, $-U_b$) anschließbar ist, **dadurch gekennzeichnet,** daß die Schalter durch Schalttransistoren (T7, T8) entgegengesetzten Leitfähigkeitstyps vorgegeben sind, deren Kollektoren zusammengeschaltet sind und die an ihren Basen durch zeitlich beabstandete Impulse (A, B) aufgesteuert werden, wobei die Sensorspule (L) zwischen dem gemeinsamen Kollektoranschluß und Bezugspotential (Masse) angeordnet ist, daß Sensorspule (L) über ein Schwellwertglied (ZD1, ZD2) an einen Kondensator (C) angeschlossen ist, wobei die Durchlaßspannung des Schwellwertgliedes so dimensioniert ist, daß sie über der durch den Sättigungsstrom in der Sensorspule (L) erzeugten Spannung liegt, und daß ein integrierender Operationsverstärker (OP, R7, C1) über einen Widerstand (R6) an den Kondensator (C) angeschlossen ist.

3. Sensor nach Anspruch 2, **dadurch gekennzeichnet**, daß das Schwellwertglied aus einer Dioden-Vollbrücke mit einer Zenerdiode in der Diagonalen besteht.

## Claims

1. Magnetic field sensor comprising a single sensing coil (L)which is fed by a saturation current in a timely sequential mode and in opposite directions, whereat the sensing coil is operated in the diagonal of a controllable full bridge circuit between an operating voltage ($U_b$) and a reference voltage and the four branches of the full bridge circuit each are comprising switching transistors (T1-T3), which are controlled crosswise and in pairs in order to produce the saturation current through the sensor coil, **characterized in that** a differential charging stage is connected to the full bridge circuit which comprises a first and a second switching transistor (T5,T6), whereat the base of the first switching transistor (T5) is connected to a first end of the sensing coil (L) and via a first diode (D1') is connected to one surface of a condenser (C) and to the collector of the second switching transistor (T6), whereat the base of the second switching transistor (T6) is connected to the other end of the sensing coil (L) and via a second diode (D1) is connected to the other surface of said condenser (C) and to the collector of the first switching transistor (T5), whereat the emitters of both switching transistors (T5,T6) are connected to the reference voltage, that the switching time (C,D) of the switching transistors (T3,T4) connecting the sensing coil (L) to the reference voltage extends timely over the switching time (A,B) of the switching transistor (T1,T2) connecting the sensing coil (L) to the operating voltage ($U_b$), and that both surfaces of the condenser (C) are connected to the inputs of an operational amplifier (OP), so that voltages appearing at switching-off of the saturation current at the sensing coil (L) are evaluated in a differential manner.

2. Magnetic field sensor comprising a single sensing coil (L), which is fed by a saturation current in a timely sequential mode and in opposite directions, whereat the sensing coil is connectable via switches (T7,T8) to voltages of different polarity ($+U_b$, $-U_b$), **characterized in that** the switches are implemented by switching transistors (T7,T8) of opposite conductivity the collectors of which are connected together and the bases of which are controlled by timely spaced pulses (A,B), whereat the sensing coil (L) is connected between the common collector terminal and reference potential (ground), that the sensing coil (L) is connected to a condenser (C) via a threshold element (ZD1,ZD2), whereat the forward voltage of the threshold element is dimensioned in such a way, that it is higher than the voltage produced by the saturation current within the sensing coil (L) and that an integrating operational amplifier (OP,R7,C1) is connected to the condenser (C) via a resistor (R6).

3. Sensor according to claim 2, **characterized in that** said threshold element consists of a full diode bridge having a Zenerdiode in its diagonal.

**Revendications**

1. Capteur de champ magnétique comportant une seule bobine (L), qui est alimentée selon une séquence temporelle et dans des directions opposées, par un courant de saturation, la bobine du capteur étant alimentée, dans la diagonale d'un circuit en pont double alternance commandable, entre une tension de fonctionnement ($U_b$) et une tension de référence, et les quatre branches du circuit en pont double alternance comportant respectivement des transistors de commutation (T1-T3), qui sont commandés par paires en croix, de manière à produire le courant de saturation dans la bobine du capteur, caractérisé en ce qu'un étage de charge différentiel est raccordé au circuit en pont double alternance, qui comprend des premier et second transistors de commutation (T5,T6), la base du premier transistor de commutation (T5) étant reliée à l'une des extrémités de la bobine (L) du capteur et étant raccordée, par l'intermédiaire d'une première diode (D1'), l'une des armatures d'un condensateur (C) et au collecteur du second transistor de commutation (T6), la base du second transistor de commutation (T6) étant reliée à l'autre extrémité de la bobine (L) du capteur et étant raccordée, par l'intermédiaire d'une seconde diode (D1), à l'autre armature du condensateur (C) et au collecteur du premier transistor de commutation (T5), les émetteurs des deux transistors de commutation (T5, T6) étant connectés à la tension de référence, en ce que la commande (C,D) des transistors de commutation (T3,T4), qui placent la bobine (L) du capteur à la tension de référence, s'étend dans le temps au-delà de la commande (A,B) des transistors de commutation (T1,T2) appliquant la tension de fonctionnement ($U_b$) à la bobine (L) du capteur, et en ce que les deux armatures du condensateur (C) sont raccordées aux entrées d'un amplificateur opérationnel (OP), de sorte que les tensions, qui apparaissent lors de l'interruption du courant de saturation sur la bobine (L) du capteur, sont exploitées de façon différentielle.

2. Capteur de champ magnétique comportant une seule bobine (L), qui est alimentée selon une séquence temporelle et dans des directions opposées par un courant de saturation, la bobine du capteur pouvant être connectée, par l'intermédiaire d'interrupteurs (T7,T8), à des tensions ayant des polarités différentes ($+U_b$, $-U_b$), caractérisé en ce que les interrupteurs sont formés par des transistors de commutation (T7,T8) ayant des types de conductivité opposés, dont les collecteurs sont interconnectés et qui sont commandés, sur leurs bases, par des impulsions (A,B) séparées dans le temps, la bobine (L) du capteur étant disposée entre la borne commune des collecteurs et le potentiel de référence (masse), en ce que la bobine (L) du capteur est raccordée, par l'intermédiaire d'un circuit à valeur de seuil (ZD1, ZD2), à un condensateur (C), la tension à l'état passant du circuit à valeur de seuil étant dimensionnée de telle sorte qu'elle soit supérieure à la tension produite par le courant de saturation dans la bobine (L) du capteur, et en ce qu'un amplificateur opérationnel intégrateur (OP, R7, C1) est raccordé par l'intermédiaire d'une résistance (R6), au condensateur (C).

3. Capteur selon la revendication 2, caractérisé en ce que le circuit à valeur de seuil est constitué par un pont double alternance de diodes comportant une diode Zener dans la diagonale.

# Fig. 1

**Fig. 1a**

**Fig. 2**

**Fig. 2a**